# EUROPEAN PATENT APPLICATION

(11) **EP 4 730 032 A1**
(43) Date of publication of application: **22.04.2026**
(21) Application number: 24206947.4
(22) Date of filing: 16.10.2024
(51) Int. Cl.: G03F 7/00, G02B 27/00

(54) **GAS FLOW APPARATUS AND METHOD FOR USE IN AN OPTICAL SYSTEM**

(71) Applicant: ASML Netherlands B.V., 5500 AH Veldhoven (NL)
(72) Inventor: BHARDWAJ, Shikhar, 5500 AH Veldhoven (NL); HUANG, Zhuangxiong, 5500 AH Veldhoven (NL)
(74) Representative: ASML Netherlands B.V.

(57) **Abstract**

A gas flow apparatus for use in an optical system comprising an optical element defining an optical surface, wherein the gas flow apparatus comprises a structure that is arranged to define an enclosure that is partially closed by the optical surface, when the gas flow apparatus is in use. The structure defines an aperture for radiation to propagate to or from the optical surface. A gas system is provided to provide a gas into the enclosure defined by the structure. Herewith, at least a portion of the gas is directed to swirl about an optical axis of the optical element. The gas has a component of velocity directed from the optical surface towards the aperture defined by the structure. A gas extractor may be arranged to extract gas from a volume that is in fluid communication with the optical surface. At least a portion of the gas is directed to swirl about a direction of net flow of the gas as it exits the volume.

## Description

### FIELD

The present invention relates to a gas flow apparatus for use in an optical system. The present invention also relates to an optical system comprising such a gas flow apparatus. The present invention has particular application in the field of lithography. The optical system my be part of an exposure apparatus that may comprise a lithographic apparatus. The present invention also relates to a method for protecting an optical surface of an optical element within such an optical system, for example an exposure apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer). Projection optics may be used to form an image of a pattern (defined by a patterning device) on such a substrate. It is desirable to avoid contaminants from impinging on optical elements of the projection optics as such contaminants may negatively affect imaging performance of the lithographic apparatus.

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, and 193 nm.

It may be desirable to provide new apparatus and methods for use in an optical system that is a part of an exposure apparatus (for example, for use in the field of lithography) that may at least partially address one or more problems associated with existing arrangements, whether identified herein or otherwise.

### SUMMARY

According to a first aspect of the present disclosure there is provided an gas flow apparatus for use in an optical system comprising an optical element defining an optical surface, the gas flow apparatus comprising: a structure arranged so as to define an enclosure (i.e., an enclosed volume), when in use, that is partially closed by the optical surface and in fluid communication with the optical surface, the structure defining an aperture for radiation to propagate to or from the optical surface; and a gas system arranged to provide gas into the enclosure defined by the structure such that at least a portion of the gas is directed to swirl about an optical axis of the optical element having a component of velocity directed from the optical surface towards the aperture defined by the structure.

The optical element may form part of optical system, for example an exposure apparatus, that may be for projecting a radiation beam onto an object. The exposure apparatus may comprise a lithographic apparatus or lithographic system. For example, the exposure apparatus may comprise a deep-ultra violet (DUV) lithographic apparatus. Such DUV lithographic apparatus may comprise refractive optics (for example lenses) and/or reflective optical elements (i.e., mirrors). The optical surface may comprise a surface that, in use, faces a patterning device or reticle within the lithographic apparatus.

Advantageously, the provision of a flow of gas from the gas system can protect the optical element (which may comprise a lens, a mirror, a sensor etc.). For example, particles and/or gaseous contaminants may be directed away from the optical surface by the flow of gas, which may prevent them from impinging on the optical surface. Such contaminants can cause a variation in the properties of radiation beam from desired or target properties, which is undesirable. Such contaminants may need to be removed from the optical element, potentially resulting in downtime or loss of throughput of the exposure apparatus, which is undesirable. Some contaminants may cause permanent damage to the optical surface of the optical elements, which is undesirable.

The gas flow apparatus according to the first aspect is particularly advantageously because at least a portion of the gas is directed to swirl about an optical axis of the optical element having a component of velocity directed from the optical surface, which has been found to provide improved protection and/or cleaning of optical elements within an exposure apparatus.

In particular, since the gas is directed to swirl about the optical axis of the optical element it may form a vortex, which may extend, for example from the optical surface towards the aperture defined by the structure (and which may attach to a second surface such as, for example, a surface of a reticle). Advantageously, this causes a dynamic pressure gradient that directs particles and contaminants away from the optical surface.

The optical axis of the optical element may be an axis of rotational symmetry of the optical element. The optical axis of the optical element may be generally perpendicular to the optical surface of the optical element. It will be appreciated that the optical surface may have a convex or concave shape and that, for such arrangements, the optical axis may be generally perpendicular to a central portion of the optical surface.

The gas system may be arranged to provide gas into the enclosure defined by the structure such that, in use, a vortex forms in the enclosure.

It will be appreciated that the particular arrangement that allows a vortex to form will be dependent on various factors such as, for example, any of the following: a size and shape of the enclosure, how the gas is introduced into the enclosure, a flow rate of gas into the enclosure, an ambient pressure surrounding the enclosure.

The gas system may be arranged to provide gas into the enclosure defined by the structure such that, in use, a vortex forms at least partially attaches to the optical surface.

Again, it will be appreciated that the particular arrangement that allows a vortex to form which attaches to the optical surface will be dependent on various factors. In general, the chances of such an arrangement (having a vortex attached to the optical surface) may be improved by providing the gas into the enclosure at position(s) that are as close to the optical surface as possible. In general, the chances of a vortex forming that is attached to the optical surface will also be dependent on an angle at which the gas is provided into the enclosure. For example, it will be appreciated that, in general, the chances of such an arrangement (having a vortex attached to the optical surface) may be improved by providing the gas into the enclosure with a suitable initial velocity component in a direction parallel to the optical axis of the optical element (i.e., directing the gas flow slightly towards the optical surface).

For example, although the gas system is arranged to provide gas into the enclosure defined by the structure such that at least a portion of the gas is directed to swirl about an optical axis of the optical element having a component of velocity directed from the optical surface, an initial velocity of the gas as it enters the enclosure may be directed towards the optical surface or may be perpendicular to the optical axis. Such arrangements may discourage flow separation between the swirling flow and the optical surface.

The gas system may be arranged to provide gas into the enclosure defined by the structure at one or more positions that are sufficiently close to the optical surface so as to allow a vortex to form that at least partially attaches to the optical surface.

The gas system may be arranged to provide gas into the enclosure defined by the structure having an initial velocity as it enters the enclosure that is directed partially towards the optical surface or which is perpendicular to the optical axis.

It will be appreciated that in order for at least a portion of the gas to have a component of velocity directed from the optical surface towards the aperture defined by the structure, the gas system may be arranged to provide gas into the enclosure defined by the structure at one or more locations between the optical surface and the aperture.

The aperture defined by the enclosure may be distal from the optical surface of the optical element.

That is, the structure may extend from the optical element generally away from the optical surface towards the aperture. The structure may extend round an optical axis of the optical element.

The structure may comprise a closed structure extending round substantially the entire perimeter of the optical surface of the optical element.

For example, the optical surface of the optical element may be generally circular in plan view (for example, the optical surface may be generally spherical and may have a convex or concave shape) and the structure may extend around substantially the entire edge or periphery (i.e., the circumference of the circle) of the optical surface.

Although the optical element may have a generally circular optical surface the aperture may have a different shape. For example, the geometry of the aperture may generally match a geometry of a radiation beam that, in use, propagates through the aperture (towards or away from the optical surface). For example, the gas flow apparatus may form part of an exposure apparatus, which may comprise a lithographic apparatus and the optical element may define an entrance to, or exit from, imaging optics of the lithographic apparatus. For such embodiments, a shape of the aperture may be similar to that of a beam of exposure radiation close to a field plane (for example proximate to a reticle or a wafer). Such a shape may be generally rectangular (and may be referred to in the art as a slit or exposure slit).

In some embodiments substantially all exit paths from the enclosure for the gas may be disposed on an opposite side of the locations at which the gas system is arranged to provide gas into the enclosure to the optical surface.

That is, the gas system is arranged to provide gas into the enclosure at one or more locations, which are disposed between the optical surface and all of the exit paths for the gas. The aperture defines one such exit path from the enclosure for the gas.

The gas flow apparatus may further comprise a gas extractor arranged to extract gas from the enclosure defined by the structure.

The gas extractor may be considered to define one or more exit paths from the enclosure for the gas. In some embodiments, the gas extractor may be arranged to extract gas from one or more locations on the structure that are disposed on an opposite side of the locations at which the gas system is arranged to provide gas into the enclosure to the optical surface. That is, the gas system is arranged to provide gas into the enclosure at one or more locations, which are disposed between the optical surface and the one or more locations at which gas is extracted by the gas extractor.

The gas extractor may comprise any combination of the features of the gas extractor of the gas flow apparatus according to the second aspect of the present disclosure, which is described below.

Advantageously, such an arrangement ensures that additional debris is not drawn towards the optical surface from the surrounding environment before it is directed away from the optical surface.

The gas flow apparatus may further be in fluid communication with a second member, when in use, that is arranged to define a second surface proximate to the aperture defined by the structure.

The second surface may generally face the optical surface. In use, the gas from the gas system may be directed to swirl about an optical axis of the optical element having a component of velocity directed from the optical surface towards the second surface.

The second member may comprise a reticle stage or mask stage which is configured, in use, to support a reticle or a mask. The reticle or mask may be arranged, in use, to define a second surface that generally faces the optical surface.

The gas from the gas system may exit the enclosure and pass through a gap between the structure and the second member.

The second member may comprise a movement mechanism arranged to move the second member in a direction that is generally perpendicular to the optical axis of the optical element such that, in use, the second surface proximate to the aperture defined by the structure also moves in said direction.

For example, the gas flow apparatus may form part of a scanning exposure apparatus that is operable to form an image of a patterning device on a substrate during a scanning exposure process. The second surface may be defined by a surface of a reticle that is scanned through an illumination slit that passes into the optical element.

The gas flow apparatus according to the first aspect of the present disclosure is particularly advantageous for such an arrangement. In particular, the gas flow apparatus according to the first aspect of the present disclosure is beneficial for such an arrangement over an arrangement wherein a gas is provided to flow over the second surface in a generally linear direction.

In some lithographic apparatus a generally linear curtain of gas is provided across a gap between a reticle and a top surface of a projection lens. In use, the reticle scans back and forth in a scanning direction through the exposure radiation. One field is exposed when the reticle moves from a first side to a second side and, subsequently, a second field is exposed as the reticle moves back from the second side to the first side and so on. However, it has been found that this can cause an asymmetry in overlay performance between fields exposed with the reticle moving in one direction and fields exposed with the reticle moving in the opposite direction. This is because the reticle is moving in a different direction with respect to the flow direction of the generally linear curtain of gas for the two different types of field. This is known as a scan up, scan down overlay effect. It is expected that this effect will be significantly reduced (or perhaps eliminated entirely) by the swirling flow provided by the gas system of the first aspect of the present disclosure as the vortex will remain more stable than the generally linear curtain of gas under the two different scanning directions of the reticle.

The gas system may comprise one or more members arranged between the optical surface and the aperture defined in the structure. The one or more members may define a nozzle that is arranged to provide the gas to an interior of the enclosure.

For example, the nozzle may provide gas to a volume defined between the second surface and the optical surface.

The nozzle may comprise a plurality of flow apertures arranged so as to impart swirl to the gas.

For example, at least two apertures may be provided at different circumferential positions around a perimeter of the optical surface. For example, each of the at least two apertures may be provided so as to direct gas generally circumferentially so as to swirl around the optical axis.

As used herein the term axial is intended to mean a direction that is parallel to an axis; radial is intended to mean a direction that is perpendicular to, and passes through the axis; and circumferential is intended to mean a direction that is generally perpendicular to the axis and the radial direction.

The nozzle may comprise one or more flow apertures shaped so as to impart swirl to the gas.

The nozzle may comprise one or more guide vanes shaped so as to impart swirl to the gas.

The gas flow apparatus may further comprise a gas source operable to deliver gas to the nozzle.

According to a second aspect of the present disclosure there is provided an gas flow apparatus for use in an optical system comprising an optical element defining an optical surface, the gas flow apparatus comprising: a gas extractor arranged to extract gas from a volume that is in fluid communication with the optical surface such that at least a portion of the gas is directed to swirl about a direction of net flow of the gas as it exits the volume.

The gas flow apparatus may form part of an optical system, e.g., an exposure apparatus, that may be for projecting a radiation beam onto an object. The exposure apparatus may comprise a lithographic apparatus or lithographic system. For example, the exposure apparatus may comprise a deep-ultra violet (DUV) lithographic apparatus. Such DUV apparatus may comprise refractive optics (for example lenses) and/or reflective optical elements (i.e., mirrors). The optical surface may comprise a surface that, in use, faces a wafer or wafer stage within the lithographic apparatus.

Advantageously, the extraction of gas from the volume that is in fluid communication with the optical surface by the gas extractor can protect the optical element (which may comprise a lens, a mirror, a sensor etc.). For example, particles and/or gaseous contaminants may be directed towards the gas extractor and therefore away from the optical surface by the flow of gas, which may prevent them from impinging on the optical surface. Such contaminants can cause a variation in the properties of radiation beam from desired or target properties, which is undesirable. Such contaminants may need to be removed from the optical element, potentially resulting in downtime or loss of throughput of the exposure apparatus, which is undesirable. Some contaminants may cause permanent damage to the optical surface of the optical elements, which is undesirable.

The gas flow apparatus according to the second aspect is particularly advantageously because at least a portion of the gas is directed to swirl about a net direction of the flow of gas as it exits the volume. The gas may form a vortex, which may extend, towards the gas extractor. Advantageously, this causes a dynamic pressure gradient that directs particles and contaminants away from the optical surface. Additional contaminants may be drawn radially inwards towards the vortex line and then can be transported to the gas extractor.

In general, the gas extractor comprises a structure that defines a gas outlet that is in fluid communication with the volume. Optionally, the gas extractor may further comprise a gas pump that is operable to pump gas from the volume through the gas outlet.

The gas extractor may comprise a structure that defines one or more flow apertures shaped so as to impart swirl to the gas as it enters the structure via the one or more flow apertures.

The gas extractor may comprise one or more guide vanes shaped so as to impart swirl to the gas as it enters the gas extractor.

The gas extractor may comprise an impeller arranged so as to impart swirl to the gas as it enters the gas extractor.

The gas flow apparatus may further comprise a gas pump operable to pump gas out of the volume that is in fluid communication with the optical surface via the gas extractor.

The gas extractor may be arranged such that, in use, a vortex forms.

Advantageously, as explained above, this can suck particles radially in towards the vortex line and then transport them along the vortex to the gas extractor. Therefore, such an arrangement may provide more protection for the optical surface than a gas extractor that is not arranged to impart swirl.

It will be appreciated that the particular arrangement that allows a vortex to form will be dependent on various factors such as, for example, any of the following: a path of least resistance towards an ambient environment, the proximity of the gas extractor to other surfaces in the vicinity of the optical surface, how the gas is extracted from the volume (i.e., what net direction and how much swirl is imparted to the flow), a flow rate of gas into the gas extractor and an ambient pressure surrounding the volume.

The gas extractor may be arranged such that, in use, a vortex forms that does not attach to the optical surface.

For example, it will be appreciated that the particular arrangement that allows a vortex to form which does not attach to the optical surface will be dependent on various factors. In general, the chances of such an arrangement (having a vortex which is not attached to the optical surface) may be improved by providing the gas extractor at a position that is closer to one or more other surfaces than to the optical surface or by closing or adjusting any gaps in the lens deign in the vicinity of the optical surface.

It is particularly desirable for the vortex to not attach to the optical surface as this may result in contaminants being first transported to the optical surface (where they may cause damage) and then towards the gas extractor.

The gas flow apparatus may further be in fluid communication with a substrate support configured to support a substrate and the gas extractor may be arranged such that, in use, a vortex forms that at least partially attaches to a substrate when supported by the substrate support.

The substrate support may comprise a wafer stage and the substrate may comprise a wafer (e.g., a resist coated silicon wafer) that is being exposed within an exposure apparatus that the gas flow apparatus according to the second aspect forms part of. Such an arrangement is particularly beneficial as various gases tend to be outgassed from resist coated wafers within a lithographic apparatus. It is desirable to keep these outgassed gases away from optical surfaces, which they may damage. By providing the gas extractor in such a way that a vortex is formed that at least partially extends from the wafer to the gas extractor, the risk that these outgassed gases are transported to the optical surface is reduced.

The gas flow apparatus may further comprise a gas system that is arranged to provide gas into the volume that is in fluid communication with the optical surface via a gas inlet.

Advantageously, providing such a gas system may decrease the likelihood that, in use, a vortex is formed that attaches to the optical surface. The gas inlet of the gas system may be disposed between the substrate support and the optical surface. The gas inlet of the gas system may be disposed opposite to and facing the gas extractor. The source of the vortical flow (which extends to the gas extractor) will, in general, depend on a path of least resistance and the presence of any gas sources or gas sinks in the vicinity of the gas extractor. Hence, by providing a limited supply flow from a gas system the vortex may be encouraged to reside below the gas inlet and away from the optical surface.

The gas inlet may be configured to impart swirl about a net direction of the gas flow as it enters the volume.

Advantageously, this may further decrease the likelihood that, in use, a vortex is formed that attaches to the optical surface.

The gas inlet of the gas system may be disposed between the substrate support and the optical surface and the gas inlet of the gas system may be disposed opposite to and facing the gas extractor.

Advantageously, this may further decrease the likelihood that, in use, a vortex is formed that attaches to the optical surface.

The gas inlet may comprise one or more apertures shaped so as to impart swirl to the gas as it leaves the gas inlet.

The gas inlet may comprise one or more guide vanes shaped so as to impart swirl to the gas as it leaves the inlet.

The gas flow apparatus may further comprise a gas source operable to deliver gas to the gas inlet of the gas system.

It will be appreciated that the gas flow apparatus according to the first aspect of the present disclosure may be combined with the gas flow apparatus according to the second aspect of the present disclosure. For example, an exposure apparatus may comprise two optical elements, each defining an optical surface.

According to a third aspect of the present disclosure there is provided an optical system comprising: a first optical element defining a first optical surface; a structure arranged so as to define an enclosure partially closed by the first optical surface, the structure defining an aperture for radiation to propagate to or from the first optical surface; a first gas system arranged to provide gas into the enclosure defined by the structure such that at least a portion of the gas is directed to swirl about an optical axis of the first optical element having a component of velocity directed from the first optical surface towards the aperture defined by the structure; a second optical element defining an second optical surface; and a gas extractor arranged to extract gas from a volume that is in fluid communication with the second optical surface such that at least a portion of the gas is directed to swirl about an axis of the gas extractor as it enters the gas extractor.

It will be appreciated that the optical system according to the third aspect of the present disclosure may comprise any of the features of the gas flow apparatus according to the first and/or second aspects as desired.

According to a forth aspect of the present disclosure there is provided a method for protecting an optical surface of an optical element, the method comprising: generating a swirling flow of gas in the vicinity of the optical surface so as to form a vortex arranged so as to reduce a number of contaminants that impinge the optical surface.

The method according to the forth aspect of the present disclosure may be carried out using the gas flow apparatus according to any one of the first and second aspects of the present disclosure.

The gas flow apparatus may comprise a structure surrounding the optical surface so as to form an enclosure partially closed by the optical surface, the structure defining an aperture for radiation to propagate to or from the optical surface; and generating the swirling flow of gas may comprise providing gas into the enclosure defined by the structure such that at least a portion of the gas is directed to swirl about an optical axis of the optical element having a component of velocity directed from the optical surface towards the aperture defined by the structure.

Such embodiments may, for example, be carried out by an gas flow apparatus according to the first or second aspect of the present disclosure.

The generation of the swirling gas flow may be such that the vortex that forms at least partially attaches to the optical surface.

The provision of gas into the enclosure defined by the structure may be at one or more positions that are sufficiently close to the optical surface so as to allow a vortex to form that at least partially attaches to the optical surface.

The provision of gas into the enclosure defined by the structure may be such that the gas has an initial velocity as it enters the enclosure that is directed partially towards the optical surface or which is perpendicular to the optical axis.

Generating the swirling flow of gas may comprise: extracting gas from a volume that is in fluid communication with the optical surface such that at least a portion of the gas is directed to swirl about a net direction of the gas flow as it exits the volume.

Such embodiments may, for example, be carried out by an exposure apparatus according to the third aspect of the present disclosure.

The extraction of the gas from the volume that is in fluid communication with the optical surface may be such that the vortex that forms does not attach to the optical surface.

The optical system, e.g., an exposure apparatus, may comprise a substrate support configured to support a substrate and the extraction of the gas from the volume that is in fluid communication with the optical surface may be such that the vortex that forms at least partially attaches to a substrate when supported by the substrate support.

The method may further comprise providing gas into the volume that is in fluid communication with the optical surface.

The gas may be provided into the volume that is in fluid communication with the optical surface such that it swirls about a net direction of the gas as it enters the volume.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 schematically shows a cross-sectional view of an gas flow apparatus according to an embodiment of the present disclosure, which may form a portion of an optical system;
- Figure 3 schematically shows a plan view of the optical surface of the optical element shown in Figure 2 with a projection of the aperture defined by the structure of the gas flow apparatus shown in Figure 2 shown in dashed lines;
- Figure 3A schematically shows a similar plan view of the optical surface of the optical element shown in Figure 2 with a projection of the aperture of the gas flow apparatus shown in Figure 2 shown in dashed lines to that shown in Figure 3 but with an alternative arrangement of outlets defined by the gas system of the gas flow apparatus shown in Figure 2 relative to the optical axis;
- Figure 4A schematically shows a cross-sectional view of the gas flow apparatus shown in Figure 2 wherein the gas system is arranged to provide gas into the enclosure defined by the structure wherein an initial velocity of the gas as it enters the enclosure is directed towards the optical surface;
- Figure 4B schematically shows a cross-sectional view of the gas flow apparatus shown in Figure 2 wherein the gas system is arranged to provide gas into the enclosure defined by the structure wherein an initial velocity of the gas as it enters the enclosure is perpendicular to the optical axis of the optical element;
- Figure 5 schematically shows a cross-sectional view of the gas flow apparatus shown in Figure 2 further comprising a gas extractor arranged to extract gas from the enclosure defined by the structure;
- Figure 6 schematically shows a cross-sectional view of an gas flow apparatus according to another embodiment of the present disclosure that may form part of an optical system; and
- Figure 7 schematically shows a cross-sectional view of a variant of the gas flow apparatus shown in Figure 6 further comprising a gas system that is arranged to provide gas into the volume that is in fluid communication with the optical surface via a gas inlet.

### DETAILED DESCRIPTION

In the present document, the terms "radiation" and "beam" are used to encompass all types of electromagnetic radiation, including ultraviolet radiation (e.g., with a wavelength of 365, 248, 193, or 157 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

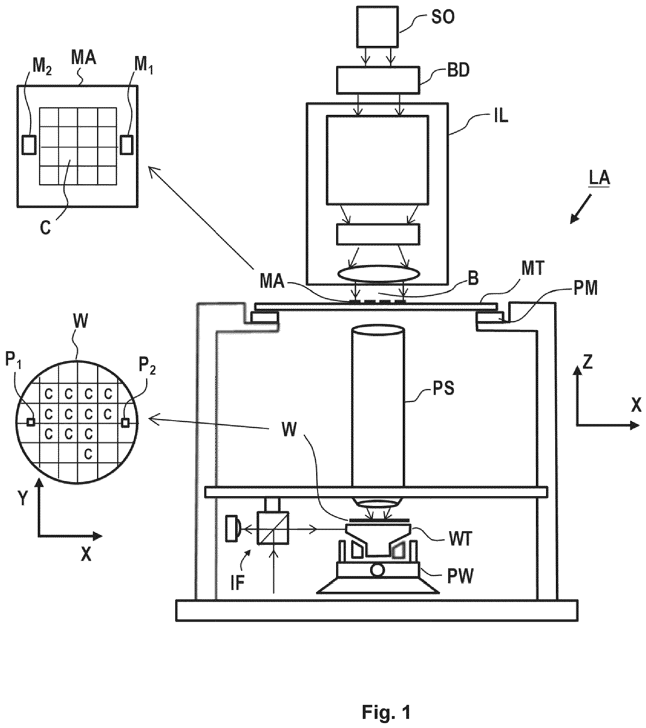

Figure 1 schematically depicts a lithographic apparatus LA. The lithographic apparatus LA includes an illumination system (also referred to as illuminator) IL configured to condition a radiation beam B (e.g., UV radiation, DUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g., via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W, on the other substrate support WT, is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions C. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

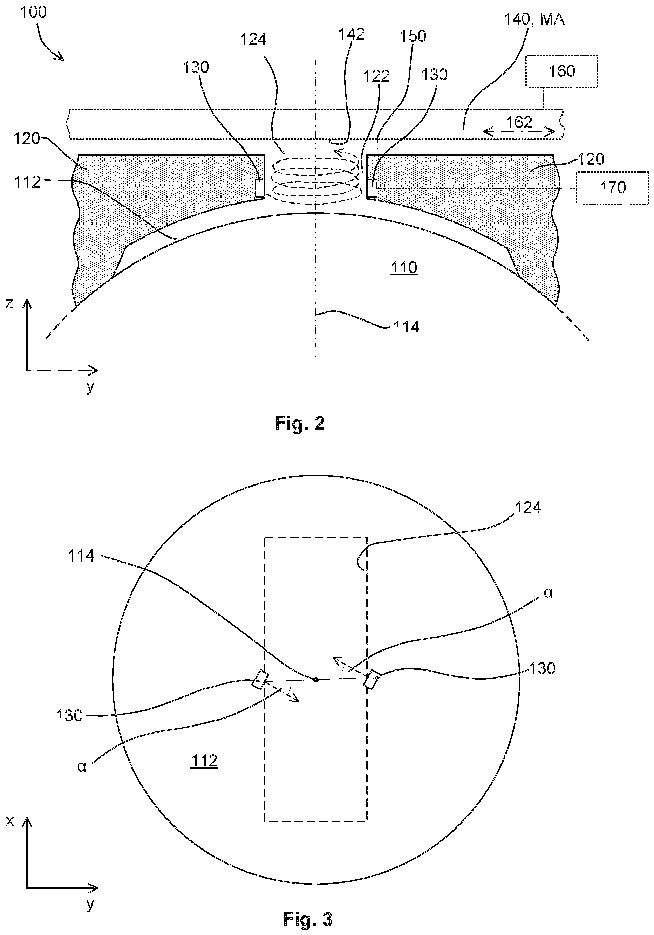

Some embodiments of the present disclosure relate to optical systems, for example exposure apparatuses, comprising arrangements that are configured so as prevent contaminants from impinging on an optical surface of an optical element (which may comprise a lens, a mirror, a sensor etc.) or at least to reduce the amount of such contaminants from impinging on the optical surface relative to known arrangements. The exposure apparatus according to such embodiments of the present disclosure may comprise a lithographic apparatus, for example one of the type shown schematically in Figure 1 and described above. The optical surface may be a surface of an optical element that forms part of the projection system PS shown in Figure 1 and described above. Such contaminants can cause a variation in the properties of radiation beam from desired or target properties, which may be undesirable. Such contaminants may need to be removed from the optical element, potentially resulting in downtime or loss of throughput of the exposure apparatus, which is undesirable. Some contaminants may cause permanent damage to the optical surface of the optical elements, which is undesirable. In particular, some embodiments of the present disclosure relate to exposure apparatus comprising arrangements that are configured to provide a flow of gas that at least partially protects the optical element. For example, particles and/or gaseous contaminants may be directed away from the optical surface by the flow of gas, which may prevent them from impinging on the optical surface. Some such embodiments of a gas flow apparatus for use in an exposure apparatus are now described with reference to Figures 2 to 7.

It will be appreciated that any suitable gas may be used. For example, the gas may comprise an inert gas, clean dry air, or the like.

Figure 2 schematically shows a schematic cross-sectional view of an gas flow apparatus 100 according to a first embodiment of the present disclosure, which may form a portion of an exposure apparatus. The gas flow apparatus 100 comprises: a structure 120; and a gas supply system 130; wherein the structure is in fluid communication with an optical surface 112 defined by an optical element 110, when in use.

The optical element 110 may, for example, comprise a first optical element of the projection system PS shown in Figure 1 and described above (i.e., an optical element of the projection system PS that is closest to the reticle stage or mask support MT). The optical surface 112 may define a first end of the projection system PS (i.e., the optical surface 112 may, in use, face the reticle stage or mask support MT).

The structure 120 is arranged so as to define an enclosure (or enclosed volume) 122 that is partially closed by the optical surface 112, when in use. The structure 120 defines an aperture 124 for radiation (for example radiation beam B) to propagate to or from the optical surface 112.

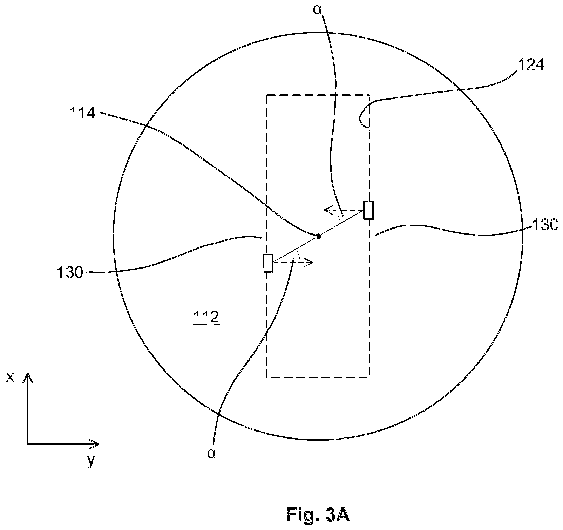

Figure 3 shows a plan view of the optical surface 112 of the optical element 110 with a projection of the aperture 124 defined by the structure 120 shown in dashed lines.

The gas system 130, which is shown very schematically as two boxes in Figures 2 and 3, is arranged to provide gas into the enclosure 122 defined by the structure 120. The flow of gas is indicated schematically using dashed arrows in Figures 2 and 3. In particular, the gas system 130 is arranged to provide gas into the enclosure 122 defined by the structure 120 such that at least a portion of the gas is directed to swirl about an optical axis 114 of the optical element 110 having a component of velocity directed from the optical surface 112 towards the aperture 124 defined by the structure 120. Note that, as explained further below, although the at least a portion of gas is directed to swirl about the optical axis 114 of the optical element 110 having a component of velocity directed from the optical surface 112 towards the aperture 124 defined by the structure 120, some portion of the gas may have a component of velocity directed towards the optical surface 112. In general, the gas system 130 may be arranged such that a net flow of the gas has a component of velocity directed from the optical surface 112 towards the aperture 124 defined by the structure 120.

In order to provide gas into the enclosure 122 defined by the structure 120 such that at least a portion of the gas is directed to swirl about the optical axis 114 of the optical element 110, the gas system 130 may be arranged to introduce the gas such that, in a plane perpendicular to the optical axis 114 (for example the x-y plane shown in Figure 3) the gas may have an initial velocity with a non-zero component perpendicular to a radial direction. For example, in a plane perpendicular to the optical axis 114 (for example the x-y plane shown in Figure 3) the gas may have an initial velocity, which is at an angle α to a radial direction. It will be appreciated that this angle α may take any suitable (non-zero) value and that the value of this angle α will, in general, depend on the location of the placement of one or more nozzles of the gas system 130 and the geometry of the enclosure 122 defined by the structure 120 that confines the vortex.

As used herein the term axial is intended to mean a direction that is parallel to an axis (for example optical axis 114); radial is intended to mean a direction that is perpendicular to, and passes through the axis; and circumferential is intended to mean a direction that is generally perpendicular to the axis and the radial direction.

Figure 3A shows a similar plan view of the optical surface 112 of the optical element 110 with a projection of the aperture 124 defined by the structure 120 shown in dashed lines to that shown in Figure 3, but with an alternative arrangement of outlets defined by the gas system 130 relative to the optical axis 114. Note that in alternative embodiments the initial flow directions may be directed more or less towards the optical axis 114 (i.e., the angle α may be smaller or larger than as shown in Figures 3 and 3A).

The gas flow apparatus 100 may form part of an optical system, for example an exposure apparatus, for projecting a radiation beam B onto an object W. The exposure apparatus may comprise a lithographic apparatus LA or lithographic system. For example, the exposure apparatus may comprise a deep-ultra violet (DUV) lithographic apparatus LA of the type shown in Figure 1 and described above. Such DUV lithographic apparatus LA may comprise refractive optics (for example lenses) and/or reflective optical elements (i.e., mirrors). The optical surface 112 may comprise a surface that, in use, faces a patterning device MA or reticle within the lithographic apparatus LA.

Advantageously, the provision of a flow of gas from the gas system 130 can protect the optical element 110 (which may comprise a lens, a mirror, a sensor etc.). For example, particles and/or gaseous contaminants may be directed away from the optical surface 112 by the flow of gas, which may prevent them from impinging on the optical surface 112. Such contaminants can cause a variation in the properties of radiation beam from desired or target properties, which is undesirable. Such contaminants may need to be removed from the optical element 110, potentially resulting in downtime or loss of throughput of an exposure apparatus that the gas flow apparatus 100 may form part of, which is undesirable. Some contaminants may cause permanent damage to the optical surface 112 of the optical elements, which is undesirable.

The gas flow apparatus 100 shown schematically in Figures 2 is particularly advantageously because at least a portion of the gas is directed to swirl about the optical axis 114 of the optical element 110 having a component of velocity directed from the optical surface 112, which has been found to provide improved protection and/or cleaning of optical elements 110 within an exposure apparatus.

In particular, since the gas is directed to swirl about the optical axis 114 of the optical element 110 it may form a vortex, which may extend, for example from the optical surface 112 towards the aperture 124 defined by the structure 120 (and which may attach to a second surface such as, for example, a surface of a reticle MA). Advantageously, this causes a dynamic pressure gradient that directs particles and contaminants away from the optical surface 112.

The optical axis 114 of the optical element 110 may be an axis of rotational symmetry of the optical element 110, a geometrical centre of the optical element 110, or a principle axis of the optical element 110. The optical axis 114 of the optical element 110 may be generally perpendicular to the optical surface 112 of the optical element 110. It will be appreciated that the optical surface 112 may have a convex or concave shape (in Figure 2 it is shown as having a convex shape) and that, for such arrangements, the optical axis 114 may be generally perpendicular to a central portion of the optical surface 112. Alternatively, the optical surface 112 may be a flat surface.

In some embodiments, the gas system 130 may be arranged to provide gas into the enclosure 122 defined by the structure 120 such that, in use, a vortex forms in the enclosure 122. It will be appreciated that the particular arrangement that allows a vortex to form will be dependent on various factors such as, for example, any of the following: a size and shape of the enclosure 122, how the gas is introduced into the enclosure 122, a flow rate of gas into the enclosure 122, and an ambient pressure surrounding the enclosure 122.

In some embodiments, the gas system 130 may be arranged to provide gas into the enclosure 122 defined by the structure 120 such that, in use, a vortex forms at least partially attaches to the optical surface 112. Again, it will be appreciated that the particular arrangement that allows a vortex to form, which attaches to the optical surface 112, will be dependent on various factors. In general, the chances of such an arrangement (having a vortex attached to the optical surface 112) may be improved by providing the gas into the enclosure 122 at position(s) that are as close to the optical surface as possible. For example, the gas may be provided into the enclosure 122 at position(s) that are as close to the optical surface as possible along the optical axis 114. In general, the chances of a vortex forming that is attached to the optical surface 112 will also be dependent on an angle at which the gas is provided into the enclosure. For example, it will be appreciated that, in general, the chances of such an arrangement (having a vortex attached to the optical surface 112) may be improved by providing the gas into the enclosure 122 with a suitable initial velocity component in a direction parallel to the optical axis 114 of the optical element 110 (i.e., directing the gas flow slightly towards or away from the optical surface 112).

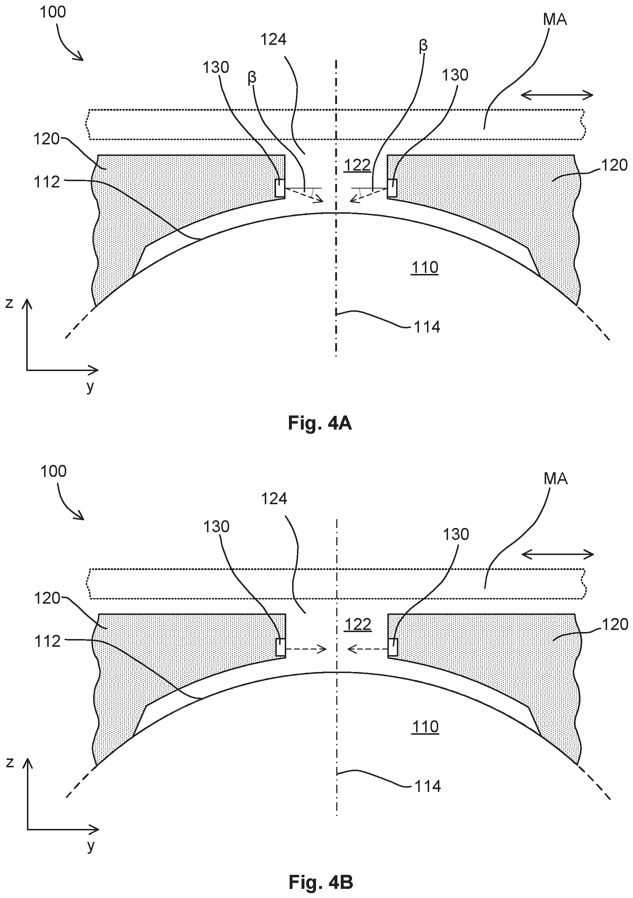

For example, although the gas system 130 is arranged to provide gas into the enclosure 122 defined by the structure 120 such that at least a portion of the gas is directed to swirl about the optical axis 114 of the optical element 110 having a component of velocity directed from the optical surface 112, an initial velocity of the gas as it enters the enclosure 122 may be directed towards the optical surface 112 (as shown schematically in Figure 4A) or may be perpendicular to the optical axis (as shown schematically in Figure 4B). Such arrangements may discourage flow separation between the swirling flow and the optical surface 112. Note that, as will be apparent from Figure 3, the flow of gas into the enclosure 122 shown in Figures 4A and 4B is merely a projection into the y-z plane and each gas flow into the enclosure 122 also has a (different) component of velocity in the x direction. For example, one of the arrows shown in each of Figure 4A and 4B represents a gas flow with a component into the page and the other one in each of Figure 4A and 4B represents a gas flow with a component out of the page.

In general, the gas system 130 may be arranged to provide gas into the enclosure 122 defined by the structure 120 having an initial velocity in a plane containing or parallel to the optical axis 114 (for example the z-y plane shown in Figure 4A) that is at an angle β to a radial direction. It will be appreciated that this angle β may take any suitable (negative, zero, or positive) value and that the value of this angle β will, in general, depend on the location of the placement of one or more nozzles of the gas system 130 and the geometry of the enclosure 122 defined by the structure 120 that confines the vortex.

In some embodiments, the gas system 130 may be arranged to provide gas into the enclosure 122 defined by the structure 120 at one or more positions that are sufficiently close to the optical surface 112 so as to allow a vortex to form that at least partially attaches to the optical surface 112.

In some embodiments, the gas system 130 is arranged to provide gas into the enclosure 122 defined by the structure 120 having an initial velocity as it enters the enclosure 122 that is directed partially towards the optical surface 112 (as shown in Figure 4A) or which is perpendicular to the optical axis 114 (as shown in Figure 4B).

It will be appreciated that in order for at least a portion of the gas to have a component of velocity directed from the optical surface 112 towards the aperture 124 defined by the structure, the gas system 130 may be arranged to provide gas into the enclosure 122 defined by the structure 120 at one or more locations between the optical surface 112 and the aperture 124.

In some embodiments, the aperture 124 defined by the enclosure 120 is distal from the optical surface 112 of the optical element 110. That is, the structure 120 may extend from the optical element 110 generally away from the optical surface 112 towards the aperture 124. The structure 120 may extend round the optical axis 114 of the optical element 110.

In some embodiments, as shown schematically in Figure 3, the structure 120 may comprise a closed structure extending round substantially the entire perimeter of the optical surface 112 of the optical element 110.

Also as shown in Figure 3, the optical surface 112 of the optical element 110 may be generally circular in plan view (for example, the optical surface 112 may be generally spherical and may have a convex or concave shape) and the structure 120 may extend around substantially the entire edge or periphery (i.e., the circumference of the circle) of the optical surface 112.

Although the optical element 110 may have a generally circular optical surface 112 (in plan view) the aperture 124 may have a different shape. For example, the geometry of the aperture 124 may generally match a geometry of a radiation beam that, in use, propagates through the aperture 124 (towards or away from the optical surface 112). For example, the gas flow apparatus 100 may form part of a lithographic apparatus LA and the optical element 110 may define an entrance to, or exit from, imaging optics (i.e., projection system PS) of the lithographic apparatus LA. For such embodiments, a shape of the aperture 124 may be similar to that of a beam of exposure radiation B close to a field plane (for example proximate to a reticle or a wafer). Such a shape may be generally rectangular or alike (and may be referred to in the art as a slit or exposure slit).

In some embodiments, the aperture 124 may define substantially the only exit path from the enclosure 122 for the gas. Advantageously, such an arrangement ensures that additional debris is not drawn towards the optical surface 112 from the surrounding environment before it is directed away from the optical surface 112.

In some embodiments, all exit paths from the enclosure 122 for the gas may be disposed on an opposite side of the locations at which the gas system 130 is arranged to provide gas into the enclosure 122 to the optical surface 112. That is, the gas system 130 may be arranged to provide gas into the enclosure 122 at one or more locations, which are disposed between the optical surface 112 and all of the exit paths for the gas. The aperture 124 defines one such exit path from the enclosure 122 for the gas.

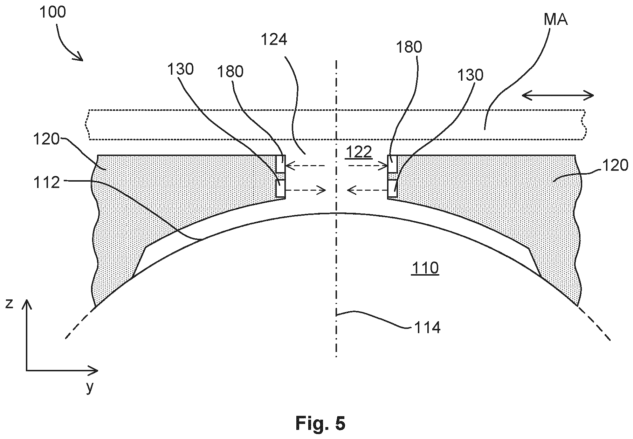

As shown schematically in Figure 5, in some embodiments the gas flow apparatus 100 may further comprise a gas extractor 180 arranged to extract gas from the enclosure 122 defined by the structure 120.

The gas extractor 180 may be considered to define one or more exit paths from the enclosure 122 for the gas. In some embodiments, the gas extractor 180 may be arranged to extract gas from one or more locations on the structure 120 that are disposed on an opposite side of the locations at which the gas system 130 is arranged to provide gas into the enclosure 122 to the optical surface 112. That is, the gas system 130 is arranged to provide gas into the enclosure 122 at one or more locations, which are disposed between the optical surface 112 and the one or more locations at which gas is extracted by the gas extractor 180.

With a suitable supply-extraction ratio of gas in the enclosure 122 defined by the structure a better flow guidance within the vortex may be achieved, even in the presence of a second member 140 or reticle MA (as described below) that may move in use.

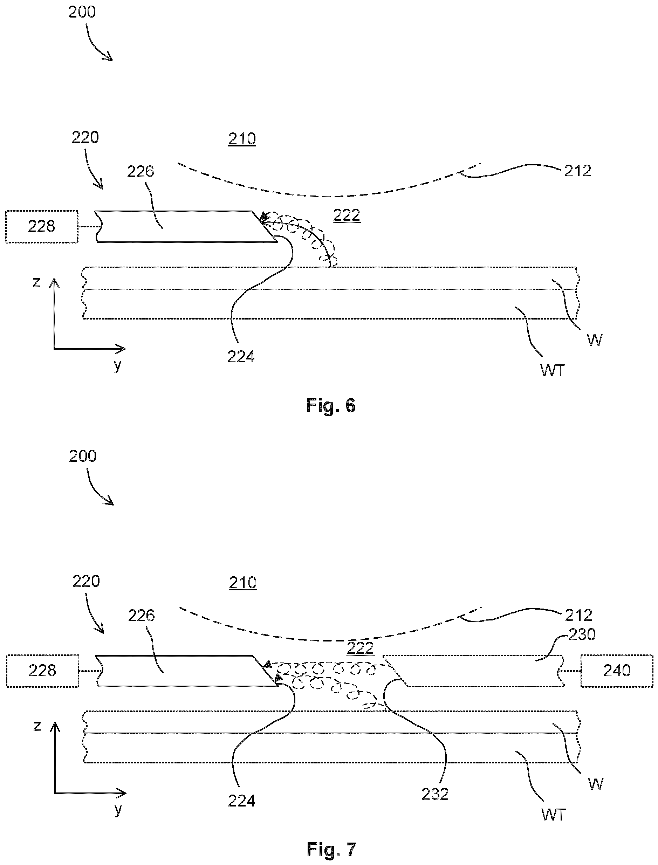

The gas extractor 180 may comprise any combination of the features of the gas extractor 220 of the gas flow apparatus 200 described below with reference to Figures 6 and 7.

In some embodiments, the gas flow apparatus 100 may be in fluid communication with a second member 140 that is arranged, in use, to define a second surface 142 proximate to the aperture 124 defined by the structure 120.

The second surface 142 may generally face the optical surface 112. In use, the gas from the gas system 130 may be directed to swirl about the optical axis 114 of the optical element 110 having a component of velocity directed from the optical surface 112 towards the second surface 142.

The second member 140 may comprise a reticle stage or mask stage MT, which is configured, in use, to support a reticle or a mask MA. The reticle or mask MA may be arranged, in use, to define a second surface 142 that generally faces the optical surface 112.

The gas from the gas system 130 may exit the enclosure 122 and pass through a gap 150 between the structure 120 and the second member 140.

In some embodiments, the second member 140 may comprise a movement mechanism 160 arranged to move the second member 140 in a direction that is generally perpendicular to the optical axis 114 of the optical element 110 such that, in use, the second surface 142 proximate to the aperture 124 defined by the structure 120 also moves in said direction. This movement is indicated schematically in Figure 2 by the double-headed arrow 162.

For example, the gas flow apparatus 100 may form part of a scanning apparatus that is operable to form an image of a patterning device MA on a substrate W during a scanning exposure process. The second surface 142 may be defined by a surface of a reticle MA that is scanned through an illumination slit that passes into the optical element 110.

The gas flow apparatus 100 shown in Figures to 5 is particularly advantageous for such an arrangement. In particular, the gas flow apparatus 100 shown in Figures 2, 4A, 4B, and 5 is beneficial for such an arrangement over an arrangement wherein a gas is provided to flow over the second surface 142, or over a pellicle provided thereon, in a generally linear direction.

In some lithographic apparatuses a generally linear curtain of gas is provided across a gap between a reticle MA and a top surface of a projection lens PS. In use, the reticle MA scans back and forth in a scanning direction through the exposure radiation. One field is exposed when the reticle MA moves from a first side to a second side and, subsequently, a second field is exposed as the reticle MA moves back from the second side to the first side and so on. However, it has been found that this can cause an asymmetry in overlay performance between fields exposed with the reticle MA moving in one direction and fields exposed with the reticle MA moving in the opposite direction. This is because the reticle MA is moving in a different direction with respect to the flow direction of the generally linear curtain of gas for the two different types of field. This is known as a scan up, scan down overlay effect. It is expected that this effect will be significantly reduced (or perhaps eliminated entirely) by the swirling flow provided by the gas system 130 of the gas flow apparatus 100 shown in Figures 2 to 5 as a vortex will remain more stable than the generally linear curtain of gas under the two different scanning directions of the reticle MA.

In some embodiments, the gas system 130 may comprise one or more members arranged between the optical surface 112 and the aperture 124 defined in the structure 120, wherein the one or more members may define a nozzle that is arranged to provide the gas to an interior of the enclosure 122. For example, the nozzle may provide gas to a volume defined 122 between the second surface 142 and the optical surface 112.

In some embodiments, the nozzle may comprise a plurality of flow apertures arranged so as to impart swirl to the gas. For example, at least two apertures may be provided at different circumferential positions around a perimeter of the optical surface 112 (as indicated schematically in Figure 3, 3A). For example, each of the at least two apertures may be provided so as to direct gas generally circumferentially so as to swirl around the optical axis 114. In some embodiments, such flow apertures (which may also be referred to as gas ports) may have chamfered edges as this may result in a better flow performance of the gas system 130. In some embodiments, such flow apertures (which may also be referred to as gas ports) may comprise sieves (i.e., an array of small apertures in a plate) as this may result in a more even velocity distribution into the enclosure 122 defined by the structure. It will be appreciated that, in general, the plurality of flow apertures (which may also be referred to as gas ports) may have different dimensions and/or flow rates. The arrangement of the sieves and dimensions thereof may differ.

In some embodiments, the nozzle may comprises one or more flow apertures shaped so as to impart swirl to the gas.

In some embodiments, the nozzle may comprises one or more guide vanes (not shown) shaped so as to impart swirl to the gas.

In some embodiments, the gas flow apparatus 100 may further comprise a gas source 170 operable to deliver gas to the nozzle of the gas system 130 via one or more channels. A control unit may be provided to control or regulate the flow rate. One or more valves may be arranged. The control unit may also control a ratio of gases when a mixture of gases is used. The control unit may control the humidity of the gas provided to the gas system 130. A thermal control unit may be provided to control the temperature of the gas that is provided to the enclosure 122.

The gas extractor 180 may extract a portion of the gas from the enclosure 122 and the extracted gas portion may be reused. Reuse to the extracted gas may comprise a gas cleaning or purifier action. A gas cleaner of purifier may be provided to treat the extracted gas. The extracted gas may be reused by providing this gas via the gas system 130 to the enclosure 122.

Figure 6 schematically shows a schematic cross-sectional view of a gas flow apparatus 200 according to a second embodiment of the present disclosure that may form part of an optical system, for example an exposure apparatus. The gas flow apparatus 200 shown in Figure 6 comprises a gas extractor 220 that is arranged, when in use, in fluid communication with an optical element 210.

The optical element 210 defines an optical surface 212. The optical element 210 may, for example, comprise a last optical element of the projection system PS shown in Figure 1 and described above (i.e., an optical element of the projection system PS that is closest to the wafer stage or substrate support WT). The optical surface 212 may define a second end of the projection system PS (i.e., the optical surface 212 may, in use, face the wafer stage or substrate support WT).

The gas extractor 220 is arranged to extract gas from a volume 222 that is in fluid communication with the optical surface 212 such that at least a portion of the gas (shown as a dashed arrow in Figure 6) is directed to swirl about a direction of net flow of the gas (shown as a solid arrow in Figure 6) as it exits the volume 222.

The gas flow apparatus 200 may form part of an optical system, for example an exposure apparatus, for projecting a radiation beam onto an object. The exposure apparatus may comprise a lithographic apparatus LA or lithographic system. For example, the exposure apparatus may comprise a deep-ultra violet (DUV) lithographic apparatus LA of the type shown in Figure 1. Such DUV apparatus may comprise refractive optics (for example lenses) and/or reflective optical elements (i.e., mirrors). The optical surface 212 may comprise a surface that, in use, faces a wafer W or wafer stage WT within the lithographic apparatus LA.

Advantageously, the extraction of gas from the volume 222 that is in fluid communication with the optical surface 212 by the gas extractor 220 can protect the optical element 210 (which may comprise a lens, a mirror, a sensor etc.). For example, particles and/or gaseous contaminants may be directed towards the gas extractor 220 and therefore away from the optical surface 212 by the flow of gas, which may prevent them from impinging on the optical surface 212. Such contaminants can cause a variation in the properties of radiation beam B from desired or target properties, which is undesirable. Such contaminants may need to be removed from the optical element 212, potentially resulting in downtime or loss of throughput of an exposure apparatus that the gas flow apparatus 200 forms part of, which is undesirable. Some contaminants may cause permanent damage to the optical surface 212 of the optical element 210, which is undesirable.

The gas flow apparatus 200 shown in Figure 6 is particularly advantageously because at least a portion of the gas is directed to swirl about a net direction of the flow of gas as it exits the volume 222. The gas may form a vortex, which may extend towards the gas extractor 220. This causes a dynamic pressure gradient that directs particles and contaminants towards the gas extractor 220. Advantageously, this prevents such particles and contaminants from impinging on the optical surface 212. Additional contaminants may be drawn radially inwards towards the vortex line (the solid arrow in Figure 6) and then can be transported to the gas extractor 220.

In general, the gas extractor 220 comprises a structure that defines a gas outlet 224 that is in fluid communication with the volume 222. Optionally, the gas extractor 220 may further comprise a gas pump 228 that is operable to pump gas from the volume 222 through the gas outlet 224.

In some embodiments, the gas extractor may comprise a structure 226 that defines one or more flow apertures shaped so as to impart swirl to the gas as it enters the structure 226 via the one or more flow apertures.

In some embodiments, the gas extractor 220 may comprise one or more guide vanes shaped so as to impart swirl to the gas as it enters the gas extractor 220. For example, the one or more guide vanes may be disposed in the structure 226.

In some embodiments, the gas extractor 220 may comprise an impeller (not shown) arranged so as to impart swirl to the gas as it enters the gas extractor 220. For example, the impeller may be disposed in the structure 226.

In some embodiments, the gas flow apparatus 200 may further comprise a gas pump 228 operable to pump gas out of the volume 222 that is in fluid communication with the optical surface 212 via the gas extractor 220.

In some embodiments, the gas extractor 220 may be arranged such that, in use, a vortex forms.

Advantageously, as explained above, this arrangement can suck particles radially in towards the vortex line (the solid arrow in Figure 6) and then transport them along the vortex to the gas extractor 220. Therefore, such an arrangement may provide more protection for the optical surface 212 than a gas extractor that is not arranged to impart swirl.

It will be appreciated that the particular arrangement that allows a vortex to form will be dependent on various factors such as, for example, any of the following: a path of least resistance towards an ambient environment, the proximity of the gas extractor 220 to other surfaces in the vicinity of the optical surface 212, how the gas is extracted from the volume 222 (i.e., what net direction and how much swirl is imparted to the flow), a flow rate of gas into the gas extractor 220 and an ambient pressure surrounding the volume 222.

In some embodiments, the gas extractor 220 may be arranged such that, in use, a vortex forms that does not attach to the optical surface 212.

For example, it will be appreciated that the particular arrangement that allows a vortex to form which does not attach to the optical surface 212 will be dependent on various factors. In general, the chances of such an arrangement (having a vortex which is not attached to the optical surface 212) may be improved by providing the gas extractor 220 at a position that is closer to one or more other surfaces than it is to the optical surface 212 or by closing or adjusting any gaps in the lens design in the vicinity of the optical surface 212.

It is particularly desirable for the vortex to not attach to the optical surface 212 as this may result in contaminants being first transported to the optical surface 212 (where they may cause damage) and then subsequently towards the gas extractor 220.

In some embodiments, in use, the gas flow apparatus 200 may be in fluid communication with a substrate support WT configured to support a substrate W. In such embodiments, the gas extractor 220 may be arranged such that, in use, a vortex forms that at least partially attaches to a substrate W when supported by the substrate support WT (as shown in Figure 6).

The substrate support WT may comprise a wafer stage and the substrate W may comprise a (resist coated) wafer that is being exposed within an exposure apparatus that the gas flow apparatus 200 forms part of. Such an arrangement is particularly beneficial as various gases tend to be outgassed from (resist coated) wafers W within a lithographic apparatus LA. It is desirable to keep these outgassed gases away from optical surfaces 212, which they may damage. By providing the gas extractor 220 in such a way that a vortex is formed that at least partially extends from the wafer W to the gas extractor 220, the risk that these outgassed gases are transported to the optical surface 212 is reduced significantly.

Figure 7 depicts a variant of the gas flow apparatus 200 illustrated in Figure 6.

As depicted in Figure 7, in some embodiments, the gas flow apparatus 200 may further comprise a gas system 230 that is arranged to provide gas into the volume 222 that is in fluid communication with the optical surface 212 via a gas inlet 232. Advantageously, by providing such a gas system 230, a vortex may be formed (shown as dotted arrow in Figure 7) that extends from the gas inlet 232 to the gas extractor 220.

In some embodiments, the gas inlet 232 may be configured to impart swirl about a net direction of the gas flow as it enters the volume 222. Advantageously, this may increase the likelihood that, in use, a vortex is formed that extends from the gas inlet 232 to the gas extractor 220, or gas outlet 224.

In some embodiments, the gas extractor 220 and the gas inlet 232 may be arranged such that, in use, a vortex is formed that extends from the gas inlet 232 to the gas extractor 220.

In some embodiments, the gas inlet 232 may comprise one or more apertures shaped so as to impart swirl to the gas as it leaves the gas inlet 232.

In some embodiments, the gas inlet 232 may comprise one or more guide vanes shaped so as to impart swirl to the gas as it leaves the inlet 232.

In some embodiments, the gas inlet 232 may have chamfered edged, which may result is a better flow performance of the gas system 230. In some embodiments, the gas inlet 232 may comprise a sieve (i.e., an array of small apertures in a plate) as this may result in a more even velocity distribution into the volume 222 that is in fluid communication with the optical surface 212.

Note that, in use, embodiments which comprise a gas system 230 that is arranged to provide gas into the volume 222 may be arranged such that multiple vortices are formed, which extend to the gas extractor 220. For example, a vortex may be formed which connects the wafer W to the gas extractor 220 (as shown schematically in Figure 6) and, simultaneously, a vortex may be formed which connects the gas system 230 to the gas extractor 220 (as shown schematically in Figure 7).

In some embodiments, the gas flow apparatus 200 may further comprise a gas source 240 operable to deliver gas to the gas inlet 232 via the gas system 230.

It will be appreciated that the first embodiment of a gas flow apparatus 100 for use in an optical system, for example an exposure apparatus, as illustrated in Figures 2 to 5 may be combined with the second embodiment of a gas flow apparatus 200 for use in an optical system, for example an exposure apparatus, as illustrated in Figures 6 and 7. For example, an exposure apparatus may comprise two optical elements 110, 210, each defining an optical surface 112, 212.

For example, some embodiments of the present disclosure relate to an optical system, for example an exposure apparatus, comprising a first embodiment of a gas flow apparatus 100 shown in Figures 2 to 5 and a second embodiment of a gas flow apparatus 200 shown in Figures 6 and 7. Such embodiments of an exposure apparatus may comprise a first optical element 110 defining the first optical surface 112 and a second optical element 210 defining the second optical surface 212. The first optical element 110 may, for example, comprise a first optical element of the projection system PS shown in Figure 1 and described above (i.e., an optical element of the projection system PS that is closest to the reticle stage or mask support MT). The first optical surface 112 may define a first end of the projection system PS (i.e., the optical surface 112 may, in use, face the reticle stage or mask support MT). Similarly, the second optical element 210 may, for example, comprise a last optical element of the projection system PS shown in Figure 1 and described above (i.e., an optical element of the projection system PS that is closest to the wafer stage or substrate support WT). The second optical surface 212 may define a second end of the projection system PS (i.e., the optical surface 212 may, in use, face the wafer stage or substrate support WT).

Some embodiments of the present disclosure relate to methods for protecting an optical surface 112, 212 of at least one optical element 110, 210 within an optical system, for example an exposure apparatus. Such optical elements may comprise, for example, a lens, a mirror, a sensor etc.. The optical surface 112, 212 may be a surface of an optical element that forms part of the projection system PS shown in Figure 1 and described above. Such contaminants can cause a variation in the properties of radiation beam from desired or target properties, which may be undesirable. Such contaminants may need to be removed from the optical element, potentially resulting in downtime or loss of throughput of the exposure apparatus, which is undesirable. Some contaminants may cause permanent damage to the optical surface of the optical elements, which is undesirable. Some such embodiments of a method for protecting an optical surface 112, 212 of at least one optical element 110, 210 within an exposure apparatus are now described.

In general, embodiments of a method for protecting an optical surface 112, 212 of at least one optical element 110, 210 within an optical system, for example an exposure apparatus, according to the present disclosure comprise generating a swirling flow of gas in the vicinity of the optical surface 112, 212 so as to form a vortex arranged so as to reduce a number of contaminants that impinge the optical surface 112, 212. It will be appreciated that such methods may be carried out using any of the gas flow apparatus 100, 200 discussed above with reference to Figures 2 to 7.

In some embodiments, the optical system, for example the exposure apparatus, comprises a structure 120 surrounding the optical surface 112 so as to form an enclosure 122 partially closed by the optical surface 122, the structure 120 defining an aperture 124 for radiation to propagate to or from the optical surface 112. For such embodiments, generating the swirling flow of gas may comprise providing gas into the enclosure 122 defined by the structure 120 such that at least a portion of the gas is directed to swirl about an optical axis 114 of the optical element 110 having a component of velocity directed from the optical surface 112 towards the aperture 124 defined by the structure 120.

Such embodiments may, for example, be carried out by the gas flow apparatus 100 illustrated in Figures 2 to 5 and as described above.

In some embodiments, the generation of the swirling gas flow may be such that the vortex that forms at least partially attaches to the optical surface 112.

In some embodiments, the provision of gas into the enclosure 122 defined by the structure 120 is at one or more positions that are sufficiently close to the optical surface 112 so as to allow a vortex to form that at least partially attaches to the optical surface 112.

In some embodiments, the provision of gas into the enclosure 122 defined by the structure 120 may be such that the gas has an initial velocity as it enters the enclosure 122 that is directed partially towards the optical surface 112 (as shown schematically in Figure 4A) or which is perpendicular to the optical axis 114 (as shown schematically in Figure 4B).

In some embodiments of the methods according to the present disclosure, generating the swirling flow of gas may comprise: extracting gas from a volume 222 that is in fluid communication with the optical surface 212 such that at least a portion of the gas is directed to swirl about a net direction of the gas flow as it exits the volume 222. Such embodiments may, for example, be carried out by an gas flow apparatus 200 of the form as shown in Figures 6 and 7 and as described above.

In some embodiments, the extraction of the gas from the volume 222 that is in fluid communication with the optical surface 112 may be such that the vortex that forms does not attach to the optical surface 212.

In some embodiments, the exposure apparatus may comprise a substrate support WT configured to support a substrate W and the extraction of the gas from the volume 222 that is in fluid communication with the optical surface 212 may be such that the vortex that forms at least partially attaches to a substrate W when supported by the substrate support WT.

In some embodiments, the method may further comprise providing gas into the volume 222 that is in fluid communication with the optical surface 212.

In some embodiments, the gas may be provided into the volume 222 that is in fluid communication with the optical surface 212 such that it swirls about a net direction of the gas as it enters the volume 222.

In some embodiments, the vortex that is formed may extend from a position 232 where the gas is provided into the volume 222 to a position 224 where the gas is extracted from the volume 222.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes, e.g., bonding, an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Aspects of the invention are set out in the clause below.
1. A gas flow apparatus for use in an optical system comprising an optical element defining an optical surface, the gas flow apparatus comprising:
   a structure arranged so as to define an enclosure that is partially closed by the optical surface, the structure defining an aperture for radiation to propagate to or from the optical surface; and
   a gas system arranged to provide gas into the enclosure defined by the structure such that at least a portion of the gas is directed to swirl about an optical axis of the optical element having a component of velocity directed from the optical surface towards the aperture defined by the structure.
2. The gas flow apparatus of clause 1, wherein the gas system is arranged to provide a gas into the enclosure defined by the structure such that, in use, a vortex forms in the enclosure.
3. The gas flow apparatus of clause 1 or clause 2 wherein the gas system is arranged to provide gas into the enclosure defined by the structure such that, in use, a vortex forms at least partially attaches to the optical surface.
4. The gas flow apparatus of any preceding clause wherein the gas system is arranged to provide gas into the enclosure defined by the structure at one or more positions that are sufficiently close to the optical surface so as to allow a vortex to form that at least partially attaches to the optical surface.
5. The gas flow apparatus of any preceding clause wherein the gas system is arranged to provide gas into the enclosure defined by the structure having an initial velocity as it enters the enclosure that is directed partially towards the optical surface or which is perpendicular to the optical axis.
6. The gas flow apparatus of any preceding clause wherein the aperture defined by the enclosure is distal from the optical surface of the optical element.
7. The gas flow apparatus of any preceding clause wherein the structure comprises a closed structure extending round substantially the entire perimeter of the optical surface of the optical element.
8. The gas flow apparatus of any preceding clause wherein substantially all exit paths from the enclosure for the gas are disposed on an opposite side of the locations at which the gas system is arranged to provide gas into the enclosure to the optical surface.
9. The gas flow apparatus of any preceding clause further comprising a gas extractor arranged to extract gas from the enclosure defined by the structure.
10. The gas flow apparatus of any preceding clause further comprising a second member that is arranged, in use, to define a second surface proximate to the aperture defined by the structure.
11. The gas flow apparatus of clause 10 further comprising a movement mechanism arranged to move the second member in a direction that is generally perpendicular to the optical axis of the optical element such that, in use, the second surface proximate to the aperture defined by the structure also moves in said direction.
12. The gas flow apparatus of any preceding clause wherein the gas system comprises one or more members arranged between the optical surface and the aperture defined in the structure, wherein the one or more members define a nozzle that is arranged to provide the gas to an interior of the enclosure.
13. The gas flow apparatus of clause 12 wherein the nozzle comprises a plurality of flow apertures arranged so as to impart swirl to the gas.
14. The gas flow apparatus of clause 12 or clause 13 wherein the nozzle comprises one or more flow apertures shaped so as to impart swirl to the gas.
15. The gas flow apparatus of any one of clauses 12 to 14 wherein the nozzle comprises one or more guide vanes shaped so as to impart swirl to the gas.
16. The gas flow apparatus of any one of clauses 12 to 15 further comprising a gas source operable to deliver gas to the nozzle.
17. An gas flow apparatus for use in an optical system comprising an optical element defining an optical surface, the gas flow apparatus comprising:
   a gas extractor arranged to extract gas from a volume that is in fluid communication with the optical surface such that at least a portion of the gas is directed to swirl about a direction of net flow of the gas as it exits the volume.
18. The gas flow apparatus of clause 17 wherein the gas extractor comprises a structure that defines one or more flow apertures shaped so as to impart swirl to the gas as it enters the structure via the one or more flow apertures.
19. The gas flow apparatus of clause 17 or clause 18 wherein the gas extractor comprises one or more guide vanes shaped so as to impart swirl to the gas as it enters the gas extractor.
20. The gas flow apparatus of any one of clauses 17 to 19 wherein the gas extractor comprises an impeller arranged so as to impart swirl to the gas as it enters the gas extractor.
21. The gas flow apparatus of any one of clauses 17 to 20 further comprising a gas pump operable to pump gas out of the volume that is in fluid communication with the optical surface via the gas extractor.
22. The gas flow apparatus of any one of clauses 17 to 21 wherein the gas extractor is arranged such that, in use, a vortex forms.
23. The gas flow apparatus of any one of clauses 17 to 22 wherein the gas extractor is arranged such that, in use, a vortex forms that does not attach to the optical surface.
24. The gas flow apparatus of any one of clauses 17 to 23 further comprising a substrate support configured to support a substrate and wherein the gas extractor is arranged such that, in use, a vortex forms that at least partially attaches to a substrate when supported by the substrate support.
25. The gas flow apparatus of any one of clauses 17 to 24 further comprising a gas system that is arranged to provide gas into the volume that is in fluid communication with the optical surface via a gas inlet.
26. The gas flow apparatus of clause 25 wherein the gas inlet is configured to impart swirl about a net direction of the gas flow as it enters the volume.
27. The gas flow apparatus of clause 25 or clause 26 when dependent either directly or indirectly on clause 24 wherein the gas inlet of the gas system is disposed between the substrate support and the optical surface and wherein the gas inlet of the gas system may is disposed opposite to and facing the gas extractor.
28. The gas flow apparatus of any one of clauses 25 to 27 wherein the gas inlet comprises one or more apertures shaped so as to impart swirl to the gas as it leaves the gas inlet.
29. The gas flow apparatus of any one of clauses 25 to 28 wherein the gas inlet comprises one or more guide vanes shaped so as to impart swirl to the gas as it leaves the inlet.
30. The gas flow apparatus of any one of clauses 25 to 29 further comprising a gas source operable to deliver gas to the gas inlet of the gas system.
31. An optical system comprising:
   a first optical element defining a first optical surface;
   a structure arranged so as to define an enclosure partially closed by the first optical surface, the structure defining an aperture for radiation to propagate to or from the first optical surface;
   a first gas system arranged to provide gas into the enclosure defined by the structure such that at least a portion of the gas is directed to swirl about an optical axis of the first optical element having a component of velocity directed from the first optical surface towards the aperture defined by the structure;
   a second optical element defining an second optical surface; and
   a gas extractor arranged to extract gas from a volume that is in fluid communication with the second optical surface such that at least a portion of the gas is directed to swirl about an axis of the gas extractor as it enters the gas extractor.
32. A method for protecting an optical surface of an optical element within an optical system, the method comprising:
   generating a swirling flow of gas in the vicinity of the optical surface so as to form a vortex arranged so as to reduce a number of contaminants that impinge the optical surface.
33.The method of clause 32 wherein the optical system comprises a structure surrounding the optical surface so as to form an enclosure partially closed by the optical surface, the structure defining an aperture for radiation to propagate to or from the optical surface; and
   wherein generating the swirling flow of gas comprises providing gas into the enclosure defined by the structure such that at least a portion of the gas is directed to swirl about an optical axis of the optical element having a component of velocity directed from the optical surface towards the aperture defined by the structure.
34. The method of clause 33 wherein the generation of the swirling gas flow is such that the vortex that forms at least partially attaches to the optical surface.
35. The method of clause 33 or clause 34 wherein the provision of gas into the enclosure defined by the structure is at one or more positions that are sufficiently close to the optical surface so as to allow a vortex to form that at least partially attaches to the optical surface.
36. The method of any one of clauses 33 to 35 wherein the provision of gas into the enclosure defined by the structure is such that the gas has an initial velocity as it enters the enclosure that is directed partially towards the optical surface or which is perpendicular to the optical axis.
37. The method of any one of clauses 33 to 36 wherein generating the swirling flow of gas comprises:
   extracting gas from a volume that is in fluid communication with the optical surface such that at least a portion of the gas is directed to swirl about a net direction of the gas flow as it exits the volume.
38. The method of clause 37 wherein the extraction of the gas from the volume that is in fluid communication with the optical surface is such that the vortex that forms does not attach to the optical surface.
39. The method of clause 37 or clause 38 wherein the optical system comprises a substrate support configured to support a substrate and wherein the extraction of the gas from the volume that is in fluid communication with the optical surface is such that the vortex that forms at least partially attaches to a substrate when supported by the substrate support.
40.The method of any one of clauses 37 to 39 further comprising providing gas into the volume that is in fluid communication with the optical surface.
41. The method of clause 40 wherein the gas is provided into the volume that is in fluid communication with the optical surface such that it swirls about a net direction of the gas as it enters the volume.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A gas flow apparatus for use in an optical system comprising an optical element defining an optical surface, the gas flow apparatus comprising:
a structure arranged so as to define an enclosure that is partially closed by the optical surface, the structure defining an aperture for radiation to propagate to or from the optical surface; and
a gas system arranged to provide gas into the enclosure defined by the structure such that at least a portion of the gas is directed to swirl about an optical axis of the optical element having a component of velocity directed from the optical surface towards the aperture defined by the structure.

2. The gas flow apparatus of claim 1, wherein the gas system is arranged to provide a gas into the enclosure defined by the structure such that, in use, a vortex forms in the enclosure.

3. The gas flow apparatus of claim 1 or claim 2 wherein the gas system is arranged to provide gas into the enclosure defined by the structure having an initial velocity as it enters the enclosure that is directed partially towards the optical surface or which is perpendicular to the optical axis.

4. The gas flow apparatus of any preceding claim wherein the structure comprises a closed structure extending round substantially the entire perimeter of the optical surface of the optical element.

5. The gas flow apparatus of any preceding claim wherein substantially all exit paths from the enclosure for the gas are disposed on an opposite side of the locations at which the gas system is arranged to provide gas into the enclosure to the optical surface.

6. The gas flow apparatus of any preceding claim further comprising a gas extractor arranged to extract gas from the enclosure defined by the structure.

7. An gas flow apparatus for use in an optical system comprising an optical element defining an optical surface, the gas flow apparatus comprising:
a gas extractor arranged to extract gas from a volume that is in fluid communication with the optical surface such that at least a portion of the gas is directed to swirl about a direction of net flow of the gas as it exits the volume.

8. The gas flow apparatus of claim 7 wherein the gas extractor comprises a structure that defines one or more flow apertures shaped so as to impart swirl to the gas as it enters the structure via the one or more flow apertures.

9. The gas flow apparatus of claim 7 or claim 8 wherein the gas extractor comprises an impeller arranged so as to impart swirl to the gas as it enters the gas extractor.

10. The gas flow apparatus of any one of claims 7 to 9 further comprising a gas system that is arranged to provide gas into the volume that is in fluid communication with the optical surface via a gas inlet.

11. An optical system comprising:
a first optical element defining a first optical surface;
a structure arranged so as to define an enclosure partially closed by the first optical surface, the structure defining an aperture for radiation to propagate to or from the first optical surface;
a first gas system arranged to provide gas into the enclosure defined by the structure such that at least a portion of the gas is directed to swirl about an optical axis of the first optical element having a component of velocity directed from the first optical surface towards the aperture defined by the structure;
a second optical element defining an second optical surface; and
a gas extractor arranged to extract gas from a volume that is in fluid communication with the second optical surface such that at least a portion of the gas is directed to swirl about an axis of the gas extractor as it enters the gas extractor.

12. A method for protecting an optical surface of an optical element within an optical system, the method comprising:
generating a swirling flow of gas in the vicinity of the optical surface so as to form a vortex arranged so as to reduce a number of contaminants that impinge the optical surface.

13. The method of claim 12 wherein the optical system comprises a structure surrounding the optical surface so as to form an enclosure partially closed by the optical surface, the structure defining an aperture for radiation to propagate to or from the optical surface; and
wherein generating the swirling flow of gas comprises providing gas into the enclosure defined by the structure such that at least a portion of the gas is directed to swirl about an optical axis of the optical element having a component of velocity directed from the optical surface towards the aperture defined by the structure.

14. The method of claim 12 or claim 13 wherein generating the swirling flow of gas comprises:
extracting gas from a volume that is in fluid communication with the optical surface such that at least a portion of the gas is directed to swirl about a net direction of the gas flow as it exits the volume.

15. The method of any one of claims 12 to 14 further comprising providing gas into the volume that is in fluid communication with the optical surface.
